# FASCICULE DE BREVET EUROPEEN

(11) **EP 3 063 248 B1**
(45) Date de publication et mention de la délivrance du brevet: **28.08.2019**
(21) Numéro de dépôt: 14825387.5
(22) Date de dépôt: 29.10.2014
(51) Int. Cl.: C09K 11/00, C08K 3/04, C08G 61/12, C08K 5/00, C08K 7/06, H01B 1/00, H01L 51/00

(54) **PROCÉDÉ DE SYNTHESE DE PEDOT-(CO) - POLYMÈRE ÉLECTROLYTE**
VERFAHREN ZUR SYNTHESE EINES PEDOT-(CO)-POLYMERELEKTROLYTS
METHOD FOR THE SYNTHESIS OF PEDOT- (CO) - POLYMER ELECTROLYTE

(30) Priorité: 31.10.2013 FR 1360681
(43) Date de publication de la demande: 07.09.2016
(73) Titulaire: Arkema France, 92700 Colombes (FR); Centre National de la Recherche Scientifique, 75794 Paris Cedex 16 (FR); Université de Bordeaux, 33000 Bordeaux (FR); Institut Polytechnique de Bordeaux, 33402 Talence Cedex (FR)
(72) Inventeur: NAVARRO, Christophe, F-64100 Bayonne (FR); ISMAILOV, Usein, F-13100 Aix en Provence (FR); MUMTAZ, Muhammad, F-33300 Bordeaux (FR); CLOUTET, Eric, F-33130 Begles (FR); BROCHON, Cyril, F-33700 Merignac (FR); HADZIIOANNOU, Georges, F-33850 Leognan (FR)
(74) Mandataire: Novagraaf Technologies
(86) Numéro de dépôt international: PCT/FR2014/052749
(87) Numéro de publication internationale: WO 2015/063415

(56) Documents cités:
- WO-A1-2013/150242
- DE-U1-202012 007 001
- US-A1- 2006 047 030
- US-A1- 2008 105 854
- US-A1- 2012 138 913

## Description

L'invention concerne un procédé de synthèse de composite Poly (3,4-éthylènedioxythiophène) -(co)-polymère -électrolyte en une seule étape.

Le poly(3,4-éthylènedioxythiophène) connu sous l'abréviation PEDOT est un polymère qui a été découvert dans les laboratoires de Bayer AG en Allemagne, en collaboration avec le groupe AGFA, à la fin des années 1980.

Il est utilisé en particulier dans les applications d'électronique organique, notamment dans les cellules photovoltaïques, mais d'une façon plus générale, dans les applications optoélectroniques, en raison de sa bonne conductivité et en particulier en raison de sa stabilité à l'oxydation et de sa transparence.

Il est utilisé conjointement à un (co)- polymère - électrolyte qui est ajouté après la synthèse de telle sorte que le complexe résultant forme un système donneur-accepteur et est soluble dans l'eau. La synthèse du PEDOT se fait en présence généralement d'un tensio-actif qui est parfois difficile à éliminer.

La demanderesse a découvert qu'un latex composite de PEDOT-(co)- polymère -électrolyte peut être préparé de façon concomitante, c'est-à-dire en une seule étape. Outre la simplification du procédé, on obtient directement le PEDOT-(co)- polymère -électrolyte, sans additif supplémentaire tels que des tensioactifs, le (co)- polymère -électrolyte jouant le rôle de stabilisant. Le latex obtenu est en outre plus stable lorsqu'il est préparé de cette manière comparativement à une addition de (co)- polymère - électrolyte à du PEDOT déjà préparé.

### Art antérieur :

Le document WO2013150242 décrit des copolymères à blocs PEDOT-bloc-polyélectrolyte utilisés comme dispersant de nanocharges. Ce document ne concerne pas un procédé de synthèse concomitant de PEDOT et de polyélectrolyte.

Le document US2012138913 décrit la synthèse de PEDOT :polystyrene sulfonate mais dans laquelle seul le momonère EDOT est utilisé conjointement au polystyrene sulfonate préalablement synthétisé.

Le document US2006047030 décrit la synthèse de PEDOT :polystyrene poly styrène acide sulfonique mais dans laquelle seul le momonère EDOT est utilisé conjointement au poly styrène acide sulfonique préalablement synthétisé.

Le document DE202012007001 décrit des complsition PEDOT :Polyélectrolytes mais dont la synthèse n'est pas faite de façon concomitante à partir des monomères EDOT et des constituant du polyélectrolyte.

Le document US2008105854 de la même manière ne décrit pas la synthèse concomitante du PEDOT et du polyélectrolyte.

### Résumé de l'invention :

La présente invention concerne un procédé de synthèse en concomitante de PEDOT et de (co)- polymère -électrolyte comprenant les étapes successives suivantes:
- préparation d'une solution d'eau et de monomère ionique sous agitation à une température comprise entre 15 et 25 °C dans un réacteur.
- introduction d'une solution d'EDOT préalablement dissout dans un solvant.
- agitation jusqu'à dissolution.
- introduction d'une dispersion solvant-monomère non ionique.
- agitation jusqu'à blanchiment de la dispersion résultante.
- mise en chauffe à une température comprise entre 35 et 55 °C.
- introduction d'une solution d'amorceur et du complément d'EDOT.
- Poursuite de l'agitation et de la chauffe parallèlement à l'introduction en continu ou semi continu de la solution de complément d'EDOT et d'amorceur.

Il est bien entendu que ce procédé peut comprendre d'autres étapes préliminaires, intermédiaires ou subséquentes à celles ci-dessus.

### Description détaillée :

Par polymérisation concomitante d'un latex composite de (poly(3,4-éthylènedioxythiophène) et de (co)-polymère électrolyte, on entend une polymérisation dans laquelle les monomères 3,4-éthylènedioxythiophène (EDOT) et les monomères précurseurs du (co)- polymère-électrolytes sont polymérisés simultanéments àl'aide du même amorceur.

Par (co)-polymère électrolyte , on entend tout polymère comprenant au moins un monomère ionique.

Il peut s'agir de toute combinaison de monomère ionique et non ionique.

Les monomères ioniques peuvent être le styrène sulfonate, les sels de l'acide acrylique, les composés porteurs de fonction phosphonyle imide ou encore sulfonyle imide. De préférence il s'agit de styrène sulfonate de sodium ou de potassium et de façon encore préférée, il s'agit de styrène sulfonate de sodium.

Les monomères non ioniques peuvent être le styrène, les styrènes substitués, les (meth)acrylates d'alkyle.

De préférence il s'agit de styrène.

La polymérisation concomitante de l'EDOT et des monomères précurseurs du (co)polymère électrolyte est effectuée en émulsion à l'aide d'un amorceur hydrosoluble. Il s'agit préférentiellement d'un persulfate et plus particulièrement du persulfate d'ammonium mais tout autre amorceur hydrosoluble peut être utilisé. Le persulfate d'ammonium permet de polymériser de façon oxydante l'EDOT en PEDOT et les monomères précurseurs du (co)polymère électrolyte en (co)polymère électrolyte de façon radicalaire. La polymérisation peut s'effectuer en batch, continu ou semi continu, avec ou non une étape préalable de synthèse de semence. De préférence la polymérisation s'effectue en semi continu. La température de synthèse est comprise entre 35 et 55 °C. de préférence entre 40 et 50 °C et de façon encore préférée entre 44 et 46°C.

Le latex composite (co)- polymère (3,4-éthylènedioxythiophène) -poly-électrolyte peut être utilisé pour disperser des nano-charges telles que les nanotubes de carbone (NTC), qu'ils soient mono ou multi-paroi, les graphènes, les fullerènes ou une combinaison de ces nano-charges.

Le latex composite (co)- polymère (3,4-éthylènedioxythiophène) -poly-électrolyte peut être utilisé pour fabriquer des films transparents conducteurs en présence ou non de nanocharges. Les films transparents conducteurs peuvent être utilisés dans les cellules organiques photovoltaiques ou toute autre application optoélectronique.

### Exemple 1 :

### Synthèse d'un latex PEDOT-Polystyrène co Polystyrène sulfonate :

Le réacteur de polymérisation est équipé d'une double enveloppe permettant la circulation d'un fluide caloporteur pour chauffer / refroidir le système, d'une tubulure permettant l'introduction d'une sonde pour mesurer la température du milieu, d'une tubulure permettant l'introduction d'azote gazeux pour chasser l'oxygène susceptible d'inhiber la réaction de polymérisation, d'un agitateur lié à un moteur permettant de tourner à vitesse variable, de deux tubulures permettant l'ajout d'additifs et d'une tubulure liée à un système de condensation / reflux.

Le réacteur est chargé de 390mg de Styrène sulfonate (1mol /équivalent) dissout dans 10 ml d'eau déminéralisée (concentration 0,04g/ml). L'agitation est mise à 450 tours par minute (rpm). Par un piquage d'azote le pied de cuve du réacteur est dégazé pendant au moins 15 minutes jusqu'à ce que la solution soit homogène. Le réacteur ensuite reste sous un flux d'azote permanent.

Dans un deuxième temps, on prépare dans des récipients adéquats les trois mélanges suivants :
a) une solution à partir de 0,2 ml (soit 266mg =1mol /équivalent) d'EDOT et de 6,6ml de l'isopropanol;
b) une dispersion de 0,15 ml (soit 137,2mg =0,6mol /équivalent) de Styrène (St) dans 3,4ml de l'isopropanol à l'aide d'un bain à ultra-son.
c) une solution de 1,057 g (soit 2,3mol/équivalent par rapport au EDOT et 0,1mol /équivalent par rapport au St+SS) de persulfate d'ammonium dans 26.4 ml d'eau déminéralisée (concentration 0,04g/ml).

Ensuite, le réacteur est mis en agitation à 600 rpm et la première solution d'EDOT (a) est introduite. La température de réaction est contrôlée à 25°C +/- 2°C. Lorsque les composants du réacteur sont mélangées la dispersion de monomère styrène (b) est introduite dans le réacteur. Suite au blanchiment du milieu réactionnel (formation de la semence de latex) la consigne de chauffe est montée de manière à atteindre la température de 45°C dans le réacteur. Lorsque cette température est atteinte, le premier quart de la solution d'amorceur (c) est introduite et la couleur du milieu réactionnel change progressivement en vert/verre-bleu ce qui montre le début de polymérisation d'EDOT. Apres 3 heures de réaction, on démarre le dosage continu à l'aide de pompes ou de pousse-seringue du restant d'amorceur (c) un quart toutes les 3 heures (3 fois), tout en maintenant la température du réacteur à 45°C +/- 2°C.

A la fin de l'ajout, la température est maintenue à 45°C+/- 2°C pendant 2 heures supplémentaires, avant de refroidir et de décharger le produit. La purification du produit final est réalisée par ultrafiltration. Le filtre utilisé est de 100 kilo-daltons. Le rendement de cette réaction se s'établit à 80%.

Le produit final a été caractérisé par les différentes techniques suivantes.

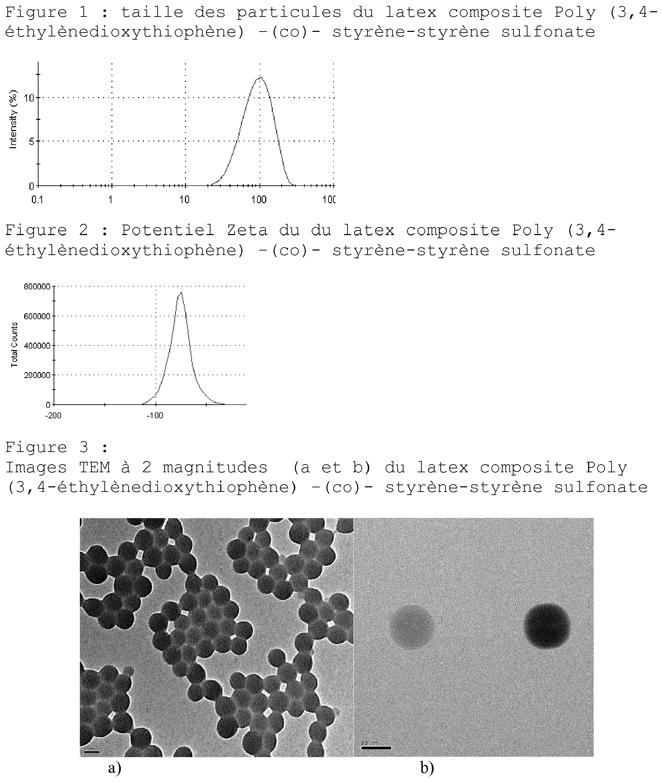

La technique de DLS (diffusion dynamique de la lumière (Dynamics Light Scattering)) montre une polydisperité (PDI) des particules de l'ordre de 0,16 et la dimension de 80nm en diamètre volumique (figure 1). Les particules sont chargées négativement et la valeur de Z-potentiel est égale à -75,8 mV (figure 2).

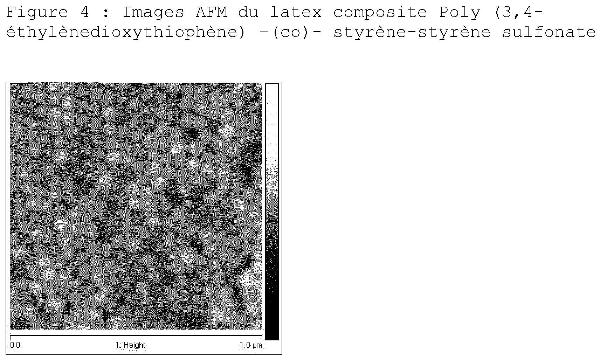

Les particules sphériques sont observées au microscope à transmission (figure 3)et AFM (figure 4).

### Exemple 2.

Le latex PEDOT-Polystyrène co Polystyrène sulfonate préparé à l'exemple 1 est comparé au latex commercial (PH1000 de la société Clevios).

Ces produits sont dispersés dans l'eau déionisée(1% massique) et soumis à un cisaillement à l'aide d'un ultraturax IKA T18, à différentes vitesses (15500, 20000, 24000 tr/min) durant 5 minutes pour chaque vitesse.

On mesure ensuite la taille des particules par DLS. Dans aucun des essais la taille des particules n'évolue pas, démontrant la bonne stabilité du produit commercial ou préparé selon l'invention.

## Revendications

1. Procédé de synthèse concomitante de poly(3,4-éthylènedioxythiophène) (PEDOT) et de (co)- polymère - électrolyte comprenant les étapes successives suivantes:
- préparation d'une solution d'eau et de monomère ionique choisi parmi le styrène sulfonate, les sels de l'acide acrylique, les composés porteurs de fonction phosphonyle imide ou encore sulfonyle imide, sous agitation à une température comprise entre 15 et 25 °C dans un réacteur.
- introduction d'une solution de 3,4-éthylènedioxythiophène (EDOT) préalablement dissout dans un solvant.
- agitation jusqu'à dissolution.
- introduction d'une dispersion solvant-monomère non ionique choisi parmi le styrène, les styrènes substitués, les (meth)acrylates d'alkyle.
- agitation jusqu'à blanchiment de la dispersion résultante signe de la formation de la semence de latex.
- mise en chauffe à une température comprise entre 35 et 55 °C.
- introduction d'une solution d'amorceur hydrosoluble choisi non limitativement parmi les persulfate et du complément d'EDOT.
- Poursuite de l'agitation et de la chauffe parallèlement à l'introduction en continu ou semi continu de la solution de complément d'EDOT et d'amorceur.

2. Procédé selon la revendication 1 dans lequel le (co)-polymère -électrolyte est constitué de styrène et de styrène sulfonate.

3. Procédé selon la revendication 1 dans lequel le (co)-polymère -électrolyte est constitué d'un sel d'acide acrylique et d'au moins un (meth) acrylate d'alkyle.

4. Procédé selon la revendication 1 dans lequel l'amorceur est hydrosoluble.

5. Procédé selon la revendication 1 dans lequel l'amorceur est un persulfate.

6. Procédé selon la revendication 1 dans lequel l'amorceur est le persulfate d'ammonium.

## Patentansprüche

1. Verfahren zur gleichzeitigen Synthese von Poly(3,4-ethylendioxythiophen) (PEDOT) und (Co-)Polymer-Elektrolyt, umfassend die folgenden aufeinanderfolgenden Schritte:
- Herstellen einer Lösung von Wasser und ionischem Monomer, ausgewählt aus Styrolsulfonat, den Salzen der Acrylsäure, Verbindungen mit einer Phosphonylimid- oder Sulfonylimidfunktion, unter Rühren bei einer Temperatur zwischen 15 und 25°C in einem Reaktor,
- Einbringen einer Lösung von zuvor in einem Lösungsmittel gelöstem 3,4-ethylendioxythiophen (EDOT),
- Rühren bis zum Lösen,
- Einbringen einer Dispersion von Lösungsmittelnichtionischem Monomer, ausgewählt aus Styrol, substituierten Styrolen, Alkyl(meth)acrylaten,
- Rühren, bis zum Bleichen der erhaltenen Dispersion, das auf die Bildung des Latexkeims hindeutet,
- Erwärmen auf eine Temperatur zwischen 35 und 55°C,
- Einbringen einer Lösung von wasserlöslichem Starter, ausgewählt, ohne Einschränkung, aus Persulfat und weiterem EDOT,
- weiteres Rühren und Erwärmen gleichzeitig mit dem kontinuierlichen oder halbkontinuierlichen Einbringen der Lösung von weiterem EDOT und Starter.

2. Verfahren nach Anspruch 1, wobei der (Co-)Polymer-Elektrolyt aus Styrol und Styrolsulfonat besteht.

3. Verfahren nach Anspruch 1, wobei der (Co-)Polymer-Elektrolyt aus einem Salz der Acrylsäure und mindestens einem Alkyl(meth)acrylat besteht.

4. Verfahren nach Anspruch 1, wobei der Starter wasserlöslich ist.

5. Verfahren nach Anspruch 1, wobei der Starter ein Persulfat ist.

6. Verfahren nach Anspruch 1, wobei der Starter Ammoniumpersulfat ist.

## Claims

1. Process for the concomitant synthesis of poly(3,4-ethylenedioxythiophene) (PEDOT) and of electrolytic (co)polymer, comprising the following successive steps:
- preparation of a solution of water and of ionic monomer chosen from styrene sulfonate, acrylic acid salts, compounds bearing a phosphonyl imide function or a sulfonyl imide function, with stirring at a temperature of between 15 and 25°C in a reactor,
- introduction of a solution of 3,4-ethylenedioxythiophene (EDOT) predissolved in a solvent,
- stirring until dissolved,
- introduction of a solvent-nonionic monomer dispersion chosen from styrene, substituted styrenes and alkyl (meth)acrylates,
- stirring until the resulting dispersion has turned white, which is a sign of the formation of the latex seeds,
- heating to a temperature of between 35 and 55°C,
- introduction of a solution of water-soluble initiator, chosen non-limitingly from persulfates, and of the remaining EDOT,
- continuation of the stirring and heating in parallel with the continuous or semi-continuous introduction of the solution of the remaining EDOT and of initiator.

2. Process according to Claim 1, in which the electrolytic (co)polymer consists of styrene and styrene sulfonate.

3. Process according to Claim 1, in which the electrolytic (co)polymer consists of a salt of acrylic acid and of at least one alkyl (meth)acrylate.

4. Process according to Claim 1, in which the initiator is water-soluble.

5. Process according to Claim 1, in which the initiator is a persulfate.

6. Process according to Claim 1, in which the initiator is ammonium persulfate.
